Europäisches Patentamt

European Patent Office

Office européen des brevets

(11) Publication number: 0 359 416
A2

## EUROPEAN PATENT APPLICATION

(21) Application number: 89308460.8

(22) Date of filing: 21.08.89

(51) Int. Cl.5 H01L 21/48 , H01L 25/16

(30) Priority: 16.09.88 GB 8821835

(43) Date of publication of application:
21.03.90 Bulletin 90/12

(84) Designated Contracting States:
DE FR IT SE

(71) Applicant: STC PLC
10, Maltravers Street
London, WC2R 3HA(GB)

(72) Inventor: McDougall, Andrew Murry
16, Kalmia Green
Gorleston Great Yarmouth Norfolk(GB)
Inventor: Winster, Anthony Eric
8, Lynn Grove
Gorleston Great Yarmouth Norfolk(GB)

(74) Representative: Dupuy, Susan Mary et al
STC Patents West Road
Harlow Essex CM20 2SH(GB)

(54) Hybrid circuits.

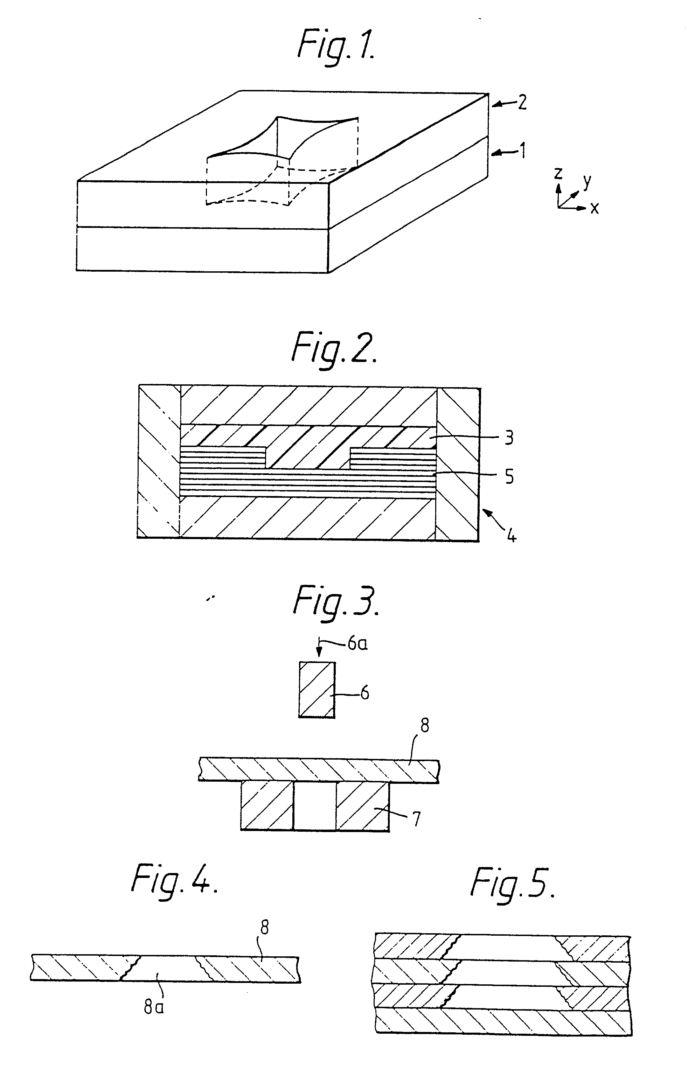

(57) In a step for laminating a stack of layers (21, 22) together in the manufacture of a low-temperature co-fired hybrid circuit having a recess, an insert (23) is disposed in the recess and a resilient pressure pad (24) disposed over the insert and stack. This serves to improve lamination and prevents bowing of the sides and base of the recess. The insert may be of metal and separate from the pressure pad or of resilient material and integral with the pressure pad (3 - Figure 2; 33 -Figure 12).

Fig.9.

## HYBRID CIRCUITS

This invention relates to hybrid circuits and in particular to co-fired hybrid circuits, and methods of manufacture thereof.

A hybrid circuit is a circuit arrangement consisting of a number of insulating layers in a multilayer structure. The layers carry conductive circuit patterns and conductive via connections can be provided between different layers through the layers. A recess or cavity can be provided in a cofired structure and one or more semiconductor devices can be mounted in the recess and electrically connected by wires to appropriate conductors of the structure, for example, which are exposed at the recess. Such cavity/recess structures have been impracticable to produce using conventional thick film techniques in which each additional layer is built up and fired in sequence, in view of the overall depth required for a suitable recess. The necessary sequential processing is very lengthy, as well as costly and yield is poor.

High temperature co-firing ceramics are available. By co-firing is meant that a multilayer structure is built up and then fired, rather than having to fire each applied layer in sequence. These co-firing ceramics fire at temperatures of the order of 1400°C and require high-temperature-resistant conductor systems such as tungsten, but this is disadvantageous due to its high resistance.

Low-temperature co-firing ceramics are now available in a flexible tape form, such as that supplied by Dupont under the designation AT 851. These materials fire at 850°C and therefore gold and silver can be used for interconnections and vias. It is possible to use silver, rather than the less mobile gold, since the structure is hermetic. A recessed multilayer structure can be readily built up from insulating sheets cut out of such a flexible tape with appropriate apertures in some of the insulating sheets. The sheets are initially cut from the tape form in which the low temperature cofiring ceramic is supplied and provided with registration holes punched in their corners. The conductive patterns and vias are then formed with use of appropriate conductive inks. The vias are formed by cutting holes through the sheets where required and filling them with a suitable conductive ink. The conductive patterns are formed by appropriate screen printing on the uppermost surface of the sheets requiring them. The next stage is to stack the sheets together with the registration holes aligned and bond them together, in a lamination process, into a unitary structure which can be fired subsequently. To maintain alignment the sheets can be stacked in a die which includes alignment pins corresponding to the registration holes. Typically, lamination may involve the use of a uniaxial press at a temperature of the order of 70 to 80°C and a pressure of the order of 3000PSI.

We have found that during the lamination step special measures must be taken if recesses with flat bases and perpendicular walls are to be achieved.

According to the present invention there is provided a method of manufacturing a co-fired hybrid circuit having a recess, the method including a laminating step in which a stack of layers, one or more of which is apertured to provide said recess, are pressed together, characterised in that during the laminating step an insert is disposed in the recess and a resilient pressure pad is disposed over an end face of the stack including the recess.

Embodiments of the invention will now be described with reference to the accompanying drawings, in which:

Figure 1 shows, somewhat schematically, the result of a basic lamination method;

Figure 2 illustrates an insert and laminating jig employed in a modified lamination method;

Figure 3 illustrates a punching operation;

Figure 4 illustrates the result of the punching operation;

Figure 5 illustrates a stack of punched sheets;

Figure 6 illustrates a further modified lamination method;

Figure 7a and 7b illustrate lamination with one size of hard tooling;

Figure 8a and 8b illustrate lamination with another size of hard tooling;

Figure 9 illustrates lamination with a hard insert and a resilient pressure pad;

Figure 10 illustrates various layers of a mould member;

Figure 11 illustrates the layers of Figure 10 bonded together;

Figure 12 illustrates forming a resilient mould member using the mould of Figure 11, and

Figures 13-15 illustrate lamination using the resilient mould member of Figure 12.

One basic method which can be employed to produce a structure as indicated in Figure 1 with a recess extending part way thereinto is to produce the structure in various stages. In a first stage the necessary layers to provide a base 1 are provided with the required conductive patterns and vias and laminated together. In a second stage, further layers which will together provide the recess walls are provided with the required conductive patterns and vias, are assembled together, the recess (cavity) is punched out and then the aperture layers are laminated together to form apertured element 2. Subsequently the base 1 and the apertured element 2 are laminated together.

Using this basic method we have found that during lamination the recess (cavity) walls tend to bow in towards the middle of the recess as indicated in Figure 1. Furthermore the base of the recess sometimes tends to bow upwards and the recess base adjacent to the recess wall tends to be poorly laminated. It should be noted that the lamination requires tight control as it is this operation which has most effect on firing shrinkage.

In an attempt to overcome these bowing and poor lamination problems we have varied the above basic method by disposing a steel insert of appropriate dimensions in the recess itself during lamination of the base 1 and the apertured element 2. This prevents the walls from bowing inwards and the base of the recess from bowing up, but we have found it very difficult to estimate the correct thickness of insert. Small deviations from the correct size lead to large variations in the lamination force across the package and as shrinkage is a function of lamination pressure this will lead to differential shrinkage causing stressing and cracking.

In order to overcome this, the basic method was further modified. Different levels of the package were laminated and then the cavity was punched where level thickness permitted. Then the overall package was partially laminated with the cavity walls and base under only low pressure (˜1500 PSI) to minimise distortion. The partially laminated package was then used as a mould to cast an integral rubber insert and pressure plate 3 (Figure 2). This insert and pressure plate 3 is used in conjunction with a laminating jig 4 to laminate a multilayer package 5. Use of a resilient (rubber) moulding compound ensures that the laminating pressure is evenly distributed all over the package including in the x, y directions. This results in a package with a flat base to the recess and straight sided recess walls, i.e. the bowing of the basic method is not obtained. There is, however, a problem caused at the punching stage illustrated schematically in Figure 3. A punch 6 co-operates with a die 7 to punch an aperture in a green (unfired) ceramic sheet 8. The punched aperture side walls of the green (unfired) tape are not perpendicular to the plane of the tape. It is a basic law of press tools that the maximum shear stress is at 45˚C to the applied force and this results in the punched holes 8a having side walls at 45° as shown in Figure 4 for a punching force applied in the direction of arrow 6a (Figure 3). A stack of such punched tapes thus presents a cavity with side walls of an irregular, substantially saw-tooth cross-section in Figure 5. The rubber moulding compound used for the insert and pressure plate applies equal pressure in all directions so there is a no tendency to iron out the irregularities in the side walls, although the bowing will be prevented.

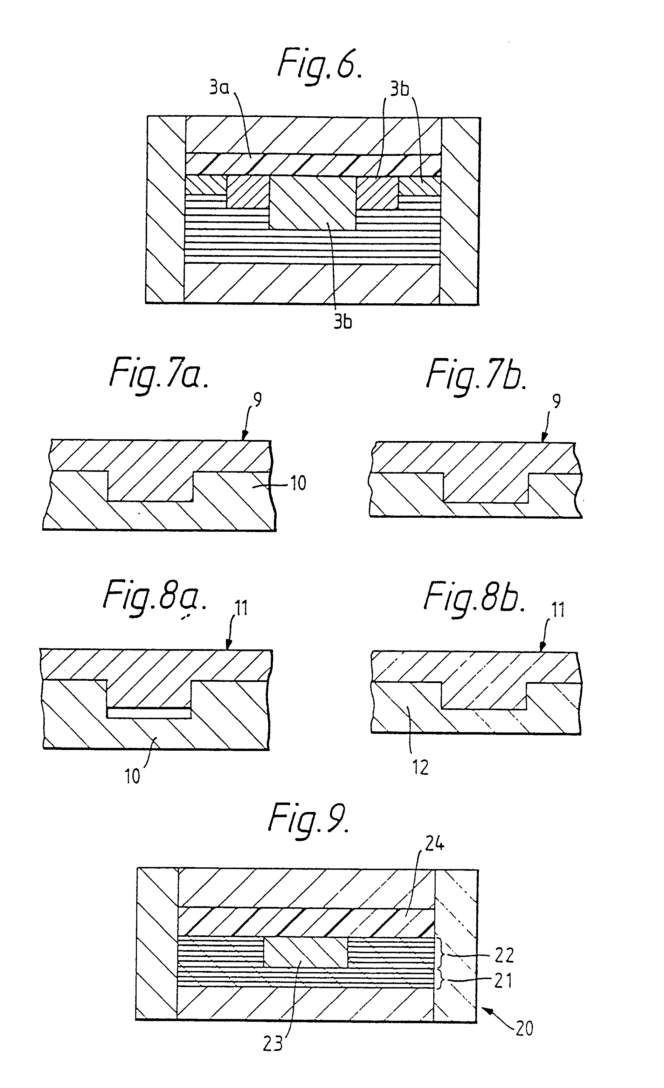

A possible solution is to combine the methods using rubber and steel inserts. Thus steel inserts 3b (Figure 6) are disposed in the cavities per se, and possibly on the top surface as shown, in order to ensure that the wall of the stepped cavity are smooth and a rubber moulding pressure pad 3a is disposed over the entire arrangement in the laminating jig in order to ensure that the insert thickness is not critical and leading to an evenly compacted substrate.

It should be noted that unitary hard tooling providing the combined functions of the steel inserts and the pressure pad over the package is disadvantageous. If unitary hard tooling 9 is dimensioned to suit the prelaminated stack of layers 10 as in Figure 7a, upon lamination (Figure 7b) the base of the package will be much more compacted than the walls of the cavity because both parts will have been reduced in thickness by the same amount but at the base this reduction in thickness is spread over less sectional thickness. As the base is compacted to a greater extent it will shrink less than the walls of the cavity when fired and thus there will be a tendency for cracks to develop. If unitary hard tooling 11 is dimensioned to suit a laminated stack 12 (Figure 8b) the rate of compaction will not be equal for all sectional thicknesses, the walls having to be compacted a certain amount before the base is affected. Thus in the partially compacted package there is a highly compressed zone associated with the walls and a non-compressed zone associated with the base and shearing between these zones is a danger. When the package is fully compacted (laminated) the zones between the base and the base of the walls may suffer from residual stressing or actual shear cracks.

We have thus found that it is beneficial to use a resilient element in the laminating process either as a pressure pad in conjunction with steel inserts in the recess proper or moulded to shape to fit the recess and provide the pressure pad as well, as described above.

Tests using a steel insert and a resilient pressure pad resulted in flat base cavities and perpendicular walls. Lamination was carried out in a jig 20 (Figure 9) of samples having a base 21 made up of four 12 thou. sheets and a cavity layer 22 made up of six 12 thou. sheets. A 65 thou. steel insert 23 was disposed in the recess. A pressure pad 24 of SCOTCHCAST (Registered Trade Mark) 281 was employed for these tests. Lamination was carried out using pressures of 3000 PSI, 3500 PSI and 4000 PSI the results were good for all pressures, with the highest pressure being particularly impressive.

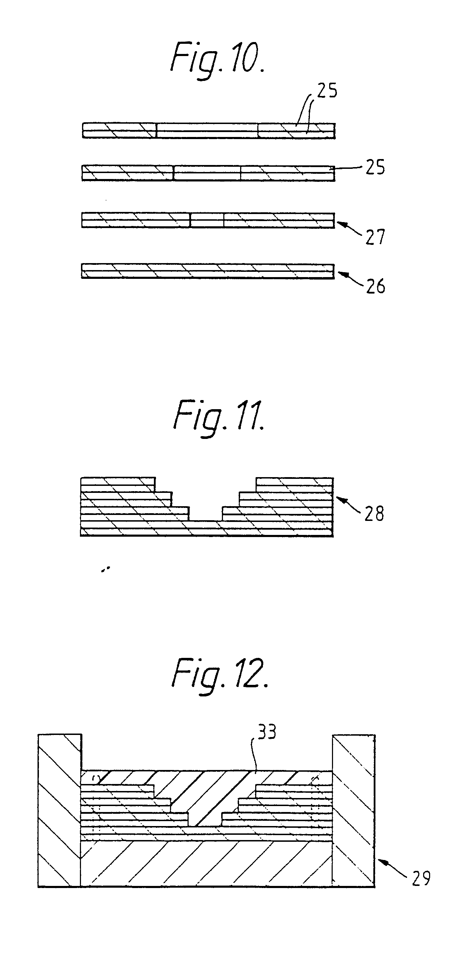

A method of manufacturing a unitary element to fit a recess and provide a pressure pad will now be described with reference to Figures 10 to 15. The recess is multi-stepped. The first step is to manufacture a mould for the recess. This comprises a model of the unfired laminated package made up by assembling a set of punched and unpunched sheets of the co-firing ceramic. The required number of sheets 25 are punched with the appropriate cavity apertures. The base 26 should be sufficiently thick to provide a flat base to the cavity and may comprise two (as shown) or more sheets. The sheets of the separate levels are laminated together using a watered down (50 - 50) PVA adhesive to glue them together. The package is laminated together one level at a time also using the watered down PVA adhesive. The lamination is preferably carried out in the laminating jig, between two MYLAR (Registered Trade Mark) sheets, which have been sprayed with a mould release agent, at a pressure of the order of 2 PSI for ten to fifteen minutes. The levels are laminated together successively, starting with the base 26, then the base to the first apertured level 27, then the next level is added and so on to produce the mould structure 28 of Figure 11. Following drying the mould is placed in lamination jig 29 (Figure 12). The inside of the jig and the top surface of the mould are sprayed with a mould release agent. A rubber moulding compound is then mixed as appropriate, de-aired by placing in a vacuum chamber and poured into the jig to a suitable height above the mould, typically 1/8" to 1/4" for sheets of the order of 3 inches square. The moulding compound is de-aired again and then cured as appropriate. For a particularly employed material, red medium viscosity silicone rubber SILASTIC (Registered Trade Mark) 3120 RTV supplied by Dow Corning, curing comprises sixteen hours at room temperature followed by twenty four hours at 70°C. There thus results a rubber mould 33.

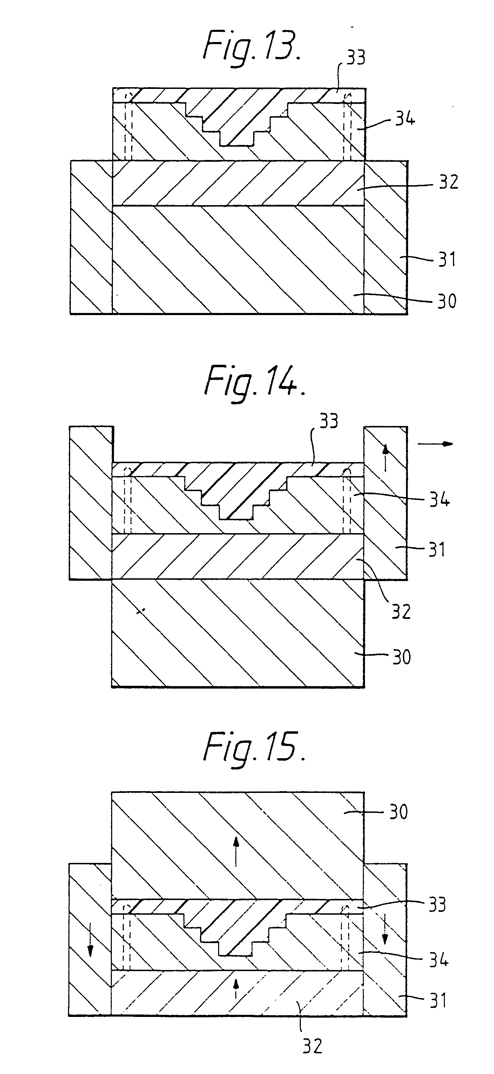

The mould is so produced it may be used for lamination as follows, referring firstly to Figure 13. Place the top plunger 30 of the laminating jig into the square jig frame 31 followed by the bottom plunger 32 i.e. that part with the location/alignment pins. A filter paper may now be placed over the jig bottom plunger 32. The package 34 of low temperature co-firing ceramic sheets is then laid up in the standard manner starting with the base and working upwards. The rubber mould 33 is placed over the laid up ceramic sheets ensuring it is properly located in the cavity. The square jig frame 31 is lifted (Figure 14) to the level of the bottom plunger 32, and the base plunger and frame slid off the top plunger which is then lowered into the frame (Figure 15). Lamination is carried out at 3500 PSI at 70°C for ten minutes. Following lamination the plungers 30 and 32 are extracted from the frame by moving the plungers upwards and the frame downwards as indicated by the arrows in Figure 14. This ensures that the edges of the package are not bent during extraction from the jig.

## Claims

1. A method of manufacturing a co-fired hybrid circuit having a recess, the method including a laminating step in which a stack of layers (21, 22), one or more of which (22) is apertured to provide said recess, are pressed together, characterised in that during the laminating step an insert (23) is disposed in the recess and a resilient pressure pad (24) is disposed over an end face of the stack including the recess.

2. A method as claimed in claim 1 characterised in that the insert is of metal.

3. A method as claimed in claim 1 characterised in that the insert (3) is integral with the resilient pressure pad.

4. A method as claimed in any one of the preceding claims characterised in that the layers are of a low-temperature co-firing ceramic material upon some of which electrically conductive patterns are provided and in some of which electrically conductive vias are provided for interconnection of the patterns of various layers.

5. A method as claimed in any one of the preceding claims characterised in that the pressure pad (24) is of silicone rubber.

6. A method as claimed in claim 1 characterised in that the recess is multi-stepped and a plurality of metal insert elements (3b) comprise said insert.

7. A method as claimed in claim 1, wherein the recess is single or multi-stepped characterised in that the insert (33) is correspondingly stepped and integral with the resilient pressure pad.

8. A method as claimed in claim 7 characterised by the step of fabricating a mould (28) to form said integral insert and pressure pad (33) by bonding together a stack of layers (25, 26, 27) of co-firing ceramic material of corresponding dimensions to said hybrid circuit layers, one or more of said layers being apertured to provide a recess corresponding to said hybrid circuit recess, and disposing the bonded stack in a laminating jig (29), and further including the steps of pouring a suitable liquid moulding material into the jig to a predetermined height above the bonded stack and curing the moulding compound.

9. A co-fired hybrid circuit manufactured by a method as claimed in any one of the preceding

claims.

*Fig.1.*

*Fig.2.*

*Fig.3.*

*Fig.4.*

*Fig.5.*

Fig.6.

Fig.7a.

Fig.7b.

Fig.8a.

Fig.8b.

Fig.9.

*Fig.10.*

*Fig.11.*

*Fig.12.*

Fig.13.

Fig.14.

Fig.15.